(19) Europäisches Patentamt
European Patent Office
Office européen des brevets

(11) **EP 2 213 771 B1**

(12) # EUROPEAN PATENT SPECIFICATION

(45) Date of publication and mention
of the grant of the patent:
**15.05.2019 Bulletin 2019/20**

(21) Application number: **08854900.1**

(22) Date of filing: **21.08.2008**

(51) Int Cl.:
*C25D 11/04* (2006.01)  *C25D 11/20* (2006.01)
*H01L 23/498* (2006.01)  *H05K 1/03* (2006.01)
*H05K 3/00* (2006.01)  *H05K 3/42* (2006.01)
*C25D 11/12* (2006.01)

(86) International application number:
**PCT/JP2008/064909**

(87) International publication number:
**WO 2009/069350 (04.06.2009 Gazette 2009/23)**

(54) **MICROFINE STRUCTURE**

MIKROFEINSTRUKTUR

STRUCTURE MICROFINE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **30.11.2007 JP 2007310112**

(43) Date of publication of application:
**04.08.2010 Bulletin 2010/31**

(73) Proprietor: **FUJIFILM Corporation Tokyo 106-0031 (JP)**

(72) Inventors:
• **HATANAKA, Yusuke**
  **Haibaragun**
  **Shizuoka 421-0302 (JP)**

• **HOTTA, Yoshinori**
  **Haibaragun**
  **Shizuoka 421-0302 (JP)**
• **UESUGI, Akio**
  **Haibaragun**
  **Shizuoka 421-0302 (JP)**

(74) Representative: **Hoffmann Eitle Patent- und Rechtsanwälte PartmbB Arabellastraße 30 81925 München (DE)**

(56) References cited:
JP-A- 3 276 512    JP-A- 4 087 213
JP-A- 2004 022 682    JP-A- 2004 285 405
JP-A- 2004 285 405    JP-A- 2007 238 988
JP-A- 2007 247 015

**Description**

TECHNICAL FIELD

The present invention relates to a manufacturing method of a microstructure.

BACKGROUND ART

An anisotropic conductive member, when inserted between an electronic component such as a semiconductor device and a circuit board, then subjected to merely the application of pressure, is able to provide an electrical connection between the electronic component and the circuit board. Accordingly, such members are widely used, for example, as inspection connectors when carrying out functional inspections of semiconductor devices and other electronic components. The anisotropic conductive member can be expected to be applied to anisotropic conductive connecting members in various devices, and connecting members for optical transmission using light transmissive materials for the substrate of the anisotropic conductive member by controlling the connecting portion as desired, and also to new graphic devices by controlling the filler arrangement.

Inspection connectors are used to avoid the large monetary losses that are incurred when, upon carrying out functional inspections after an electronic component such as a semiconductor device has been mounted on a circuit board, the electronic component is found to be defective and the circuit board is discarded together with the electronic component.

That is, by bringing electronic components such as semiconductor devices into electrical contact with a circuit board through an anisotropic conductive member at positions similar to those to be used during mounting and carrying out functional inspections, it is possible to perform the functional inspections without mounting the electronic components on the circuit board, thus enabling the above problem to be avoided.

Such an anisotropic conductive member is described in JP 2000-012619 A, which discloses "an anisotropic conductive film comprising a film substrate composed of an adhesive insulating material and a plurality of conductive paths composed of an electrically conductive material which are arrayed within the film substrate in a mutually insulated state and pass entirely through the film substrate in a thickness direction thereof, wherein the conductive paths have shapes, in a cross-section parallel to a lengthwise direction of the film substrate, with circumferences having thereon an average maximum length between two points of from 10 to 30 $\mu$m, and wherein neighboring conductive paths have intervals therebetween which are from 0.5 to 3 times the average maximum length."

JP 2005-085634 A discloses "an anisotropic conductive film comprising a film base composed of an insulating resin and a plurality of conductive paths which are mutually insulated, pass entirely through the film base in a thickness direction thereof and are positioned in staggered rows, wherein conductive paths in mutually neighboring conductive path rows have a smaller distance therebetween than conductive paths within a single row of conductive paths."

JP 2000-012619 A and JP 2005-085634 A disclose methods of manufacturing such anisotropic conductive films in which fine wires of an anisotropic conductive material are inserted into an insulating film, the elements are integrally united by the application of heat and pressure, and scribing is subsequently carried out in the thickness direction.

JP 2002-134570 A examines a method of manufacturing an anisotropic conductive film which involves electroforming conductive columns using a resist and a mask, then pouring an insulating material in the columns and solidifying the insulating material.

JP 03-182081 A discloses "a method of manufacturing an electrically connecting member having a retaining body made of an electrically insulating material and a plurality of conductive elements provided in a mutually insulating state within the retaining body, wherein an end of each conductive element is exposed on a side of the retaining body and the other end of each conductive element is exposed on the other side of the retaining body, the method comprising:

a first step of exposing a matrix having a base and an insulating layer which, when deposited on the base, forms the retaining body to a high energy beam from the insulating layer side, thereby removing all of the insulating layer and part of the base in a plurality of regions so as to form a plurality of holes in the matrix;

a second step of filling the plurality of formed holes with a conductive material for forming the conductive elements so as to be flush with the sides of the insulating layer or to protrude from the sides; and a third step of removing the base." JP 03-182081 A also carries out investigations on various materials (e.g., polyimide resins, epoxy resins and silicone resins) as the insulating layer.

However, with the increasing trend in recent years toward higher integration, electrode (terminal) sizes in electronic components such as semiconductor devices are becoming smaller, the number of electrodes (terminals) is increasing, and the distance between terminals is becoming tighter. Moreover, there have also appeared electronic components having a surface construction wherein the surface on each of the numerous terminals arranged at a tight pitch lies at a position that is more recessed than the surface of the component itself.

In order to be able to adapt to such electronic components, there has arisen a need to make the outer diameter (thickness) of the conductive paths in anisotropic conductive members smaller and to arrange the conductive paths in a tighter pitch.

However, in the methods of manufacturing the anisotropic conductive films and electrically connecting members described in the above patent documents, it has been very difficult to reduce the size of the conductive paths. A method of controlling the array of the conductive paths cannot be found out on the order of the tight pitch.

JP 2004 285405 A describes a method for preparing a microelectrode array by using an anodically oxidized porous alumina with regularly and ideally arranged pores.

DISCLOSURE OF THE INVENTION

PROBLEMS TO BE SOLVED BY THE INVENTION

It is therefore an object of the invention to provide a microstructure that can be employed as an anisotropic conductive member or an optical transmission member which can dramatically increase the density of conductive paths, be used as inspection connectors and the like for electronic components such as semiconductor devices even today when still higher levels of integration have been achieved, and control the array of the conductive paths as desired. Another object of the invention is to provide a method of manufacturing such a microstructure.

MEANS FOR SOLVING THE PROBLEMS

The inventors have made an intensive study to achieve the above objects and discovered a manufacturing method in which an aluminum anodized film is used for the insulating base to control the portions within the film through which micropores are to pass thus enabling the density of the conductive paths to be dramatically increased while controlling the array itself of the conductive paths, and the invention has been completed.

Specifically, the invention provides the following (10) to (14), while the Items (1) to (9) no longer fall within the scope of protection of the present application.

(1) A microstructure comprising a base having through micropores at a density of at least $10^7$ micropores/mm$^2$ wherein part of the through micropores are filled with other material than a material of the base.

(2) The microstructure according to (1), wherein the base is an insulating base.

(3) The microstructure according to (1) or (2), wherein the base comprises alumina.

(4) The microstructure according to any one of (1) to (3), wherein the through micropores are in a straight tube shape.

(5) The microstructure according to any one of (1) to (4), wherein the through micropores have a degree of ordering as defined by formula (i):

$$\text{Degree of ordering } (\%) = B/A \times 100 \quad (i)$$

(wherein A represents a total number of through micropores in a measurement region, and B represents a number of specific through micropores in the measurement region for which, when a circle is drawn so as to be centered on a center of gravity of a specific through micropore and so as to be of a smallest radius that is internally tangent to an edge of another through micropore, the circle includes centers of gravity of six through micropores other than the specific through micropore) of at least 50%.

(6) The microstructure according to any one of (1) to (5), wherein the other material than the material of the base filled into the through micropores are exposed at surfaces of the base.

(7) The microstructure according to any one of (1) to (5), wherein the other material than the material of the base filled into the through micropores are protruded from surfaces of the base.

(8) The microstructure according to any one of (1) to (7), wherein the material filled into the through micropores is an electrically conductive material.

(9) The microstructure according to any one of (1) to (8), wherein the through micropores have a diameter of 10 to 1000 nm.

(10) A method of manufacturing a microstructure comprising a base having through micropores at a density of at least $10^7$ micropores/mm$^2$, part of the through micropores being filled with other material than a material of the base, wherein an aluminum substrate is subjected at least to, in order,

a treatment (A) for anodizing the aluminum substrate to form an oxide film having micropores;

a treatment (B) for removing aluminum from the oxide film obtained by the treatment (A);

a treatment (C) for perforating part of the micropores present in the oxide film from which the aluminum was removed by the treatment (B);

a treatment (D) for filling the part of the micropores that were perforated by the treatment (C) with a different material from an oxide film material; and a step (E) of surface planarization for removing bottoms of micropores of the oxide film that were not perforated in the treatment (C) to make the unperforated micropores extend through the oxide film, wherein, before performing the treatment (A), the surface of the aluminum substrate (12) is subjected to a mirror-like finishing treatment, and wherein, in order to perforate the part of the micropores present in the oxide film in the treatment (C), the treatment (C) comprises at least a treatment (C') which comprises forming a pattern which is insoluble or hardly soluble in an acid or an alkali on a surface of the oxide film after removal of the aluminum, and dissolving portions other than the pattern in the oxide film by using the acid or the alkali to make the micropores formed in the portions other than the pattern in the oxide film extend through the oxide film.

(11) The microstructure manufacturing method according to (10), wherein the treatment (C') comprises at least a treatment (C'-1) which comprises forming a photosensitive layer in which solubility with respect to the acid or the alkali changes in response to light on the surface of the oxide film after the removal of the aluminum, irradiating the photosensitive layer with light beams and dissolving the photosensitive layer by using the acid or the alkali to form the pattern which is insoluble or hardly soluble in the acid or the alkali on the surface of the oxide film after the removal of the aluminum.

(12) The microstructure manufacturing method according to (10), wherein the treatment (C') comprises at least a treatment (C'-2) which comprises forming a thermosensitive layer in which solubility with respect to the acid or the alkali changes in response to heat on the surface of the oxide film after the removal of the aluminum, heating the thermosensitive layer and dissolving the thermosensitive layer by using the acid or the alkali to form the pattern which is insoluble or hardly soluble in the acid or the alkali on the surface of the oxide film after the removal of the aluminum.

(13) The microstructure manufacturing method according to any one of (10) to (12), wherein, in the treatment (D), the different material from the oxide film material filled into the micropores that were made to extend through the oxide film by the treatment (C) is an electrically conductive material.

(14) The microstructure manufacturing method according to (13), wherein, in the treatment (D), the micropores that were made to extend through the oxide film by the treatment (C) are filled with the electrically conductive material by electrolytic plating.

EFFECTS OF THE INVENTION

As shown below, the microstructure obtained by the method of the invention can be preferably used as an anisotropic conductive member. The anisotropic conductive member using the microstructure dramatically increases the conductive path density and, even today when still higher levels of integration have been achieved, can be used as inspection connectors and the like for electronic components such as semiconductor devices.

The anisotropic conductive member using the microstructure obtained by the method of the invention have a large number of conductive paths connected to the electrode (pads) of an electronic component and the pressure is dispersed, and therefore damage to the electrode can be reduced. Since the large number of conductive paths are connected to (in contact with) the single electrode, the influence on the whole confirmation of the conductivity is minimized even in the event of failure in part of the conductive paths. In addition, the load on the positioning of an evaluation circuit board can be considerably reduced.

Furthermore, the method of manufacturing a microstructure according to the invention is capable of controlling the conductive paths as desired and therefore this invention can be applied to the optical transmission materials, graphic materials and various other devices and is very useful.

BRIEF DESCRIPTION OF THE DRAWINGS

FIGS. 1A and 1B are simplified views showing a preferred embodiment of an anisotropic conductive member; FIG. 1A being a front view and FIG. 1B being a cross-sectional view taken along the line IB-IB of FIG. 1A.

FIGS. 2A and 2B are diagrams illustrating a method for computing the degree of ordering of micropores.

FIGS. 3A to 3D are schematic end views for illustrating anodizing treatment in the manufacturing method of the invention.

FIGS. 4A to 4D are schematic end views for illustrating metal filling treatment and other treatments in the manufacturing method of the invention.

FIG. 5 is an SEM image of a surface profile after pattern image formation and removal of the bottom of an anodized film.

[DESCRIPTION OF SYMBOLS]

1 Microstructure
2 Insulating base
2a, 2b Surface of the insulating base
3, 4 Through micropore
5 Conductive path
6a, 6b Protrusion
7 Thickness of the insulating base
8 Width between neighboring conductive paths
9 Diameter of the conductive path
10 Center-to-center distance (pitch) between neighboring conductive paths
12 Aluminum substrate
14a, 14b, 14c, 14d Anodized film
16a, 16b, 16c, 16d Micropore
18a, 18b, 18c, 18d Barrier layer
20 Insulating base
21 Microstructure
101, 102, 104, 105, 107, 108 Micropore
103, 106, 109 Circle

BEST MODE FOR CARRYING OUT THE INVENTION

The microstructure obtained by the method of the present invention and its manufacturing method according to the invention are described below in detail.

The microstructure obtained by the method of the invention is one comprising a base having through micropores at a density of at least $10^7$ micropores/mm$^2$ and part of the through micropores are filled with other material than the base material. In cases where the through micropores are filled with an electrically conductive material, the microstructure can be used as the anisotropic conductive member in which the electrically conductive material makes up the conductive paths.

In cases where the microstructure obtained by the method of the invention is used as the anisotropic conductive member, the base should be an insulating base and the through micropores should be in a straight tube shape.

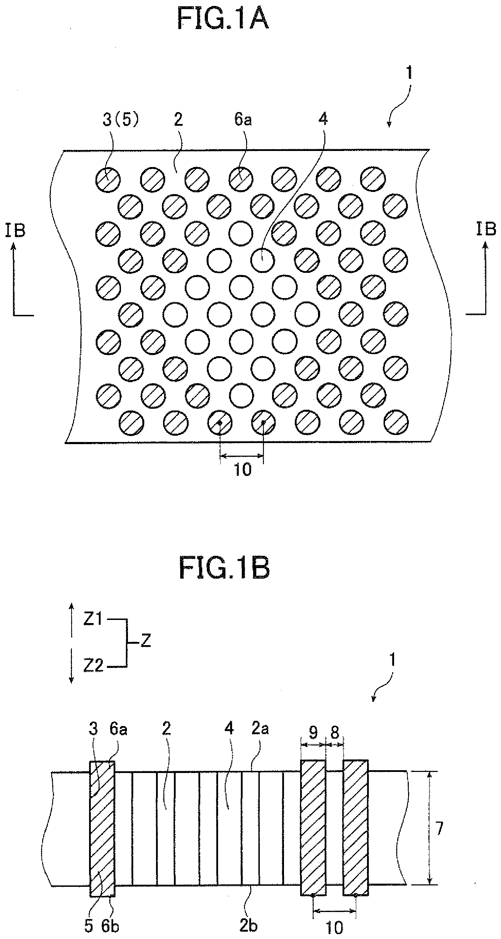

Next, the case in which the microstructure obtained by the method of the invention is used as the anisotropic conductive member is described with reference to FIG. 1.

FIG. 1 shows simplified views showing a preferred embodiment of a microstructure obtained by the method of the invention. FIG. 1A is a front view and FIG. 1B is a cross-sectional view taken along the line IB-IB of FIG. 1A.

A microstructure 1 obtained by the method of the invention comprises an insulating base 2 which has straight tube-shaped through micropores 3, 4 at a density of at least $10^7$ micropores/mm$^2$. The straight tube-shaped through micropores 3, 4 refer to those having axes substantially parallel (parallel in FIG. 1) to the thickness direction Z of the insulating base 2 and also having diameters substantially identical in the axial direction. The expression "through micropores 3, 4 having axes substantially parallel to the thickness direction Z of the insulating base 2" refers to those having an angular deviation with respect to the thickness direction Z of the insulating base 2, of not more than 10°, preferably not more than 5° and more preferably not more than 3°. The expression "through micropores 3, 4 having diameters substantially identical in the axial direction" refers to those having a diameter deviation $\Delta D$ as represented by the following formula of not more than 10%, preferably not more than 7% and more preferably not more than 5%.

$$\Delta D = (D_{max} - D_{min}) / D_{ave} \times 100 \ (\%)$$

$D_{max}$ is the maximum diameter of the through micropores 3, 4; $D_{min}$ is the minimum diameter of the through micropores 3, 4;
$D_{ave}$ is the average diameter of the through micropores 3, 4.

In the microstructure 1 obtained by the method of the invention, part of the through micropores 3, 4 (through micropores 3 in FIG. 1) are filled with an electrically conductive material, thus forming conductive paths 5. In other words, the microstructure 1 shown in FIG. 1 includes the plurality of conductive paths 5 formed by filling the through micropores 3 with the electrically conductive material and a plurality of paths formed from the through micropores 4 into which no electrically conductive material is filled.

Each conductive path 5 is required to have one end exposed at one surface of the insulating base 2 and the other end exposed at the other surface of the insulating base 2. In other words, in cases where the microstructure 1 obtained by the method of the invention is used as the anisotropic conductive member, the electrically conductive material filled into the through micropores 3 is required to be exposed at the surfaces of the insulating base 2. As shown in FIG. 1B, the electrically conductive material filled into the through micropores 3 are preferably protruded from surfaces 2a and 2b of the insulating base. More specifically, each conductive path 5 preferably has one end protruded from the surface 2a on one side of the insulating base 2 and the other end protruded from the surface 2b on the other side of the insulating base 2. In other words, both the ends of each conductive path 5 preferably have protrusions 6a and 6b protruded from the main surfaces 2a and 2b of the insulating base, respectively.

Next, the materials and dimensions of the respective components of the microstructure are described.

[Insulating Base]

The insulating base 2 making up the microstructure 1 obtained by the method of the invention has the through micropores 3, 4 at a density of at least $10^7$ micropores/mm$^2$. The insulating base should have an electric resistivity of $10^{14}$ $\Omega\cdot$cm which is equivalent to that of an insulating base (e.g., a thermoplastic elastomer) making up a conventionally known anisotropic conductive film.

The insulating base is not particularly limited as long as the above-described requirements are satisfied. However, alumina is preferred because the insulating base can be easily manufactured by using the microstructure manufacturing method of the invention to be described later.

From the viewpoint that the density of the through micropores can be increased, the through micropores in the insulating base making up the microstructure obtained by the method of the invention preferably have a degree of ordering, as defined by formula (i):

$$\texttt{Degree of ordering (\%) = B/A} \times \texttt{100 \quad (i)}$$

(wherein A represents the total number of through micropores in a measurement region, and B represents the number of specific through micropores in the measurement region for which, when a circle is drawn so as to be centered on the center of gravity of a specific through micropore and so as to be of the smallest radius that is internally tangent to the edge of another through micropore, the circle includes the centers of gravity of six through micropores other than the specific through micropore) of at least 50%.

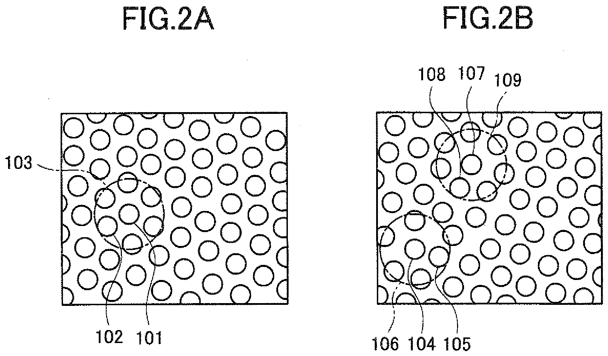

FIG. 2 shows diagrams illustrating the method for computing the degree of ordering of the through micropores. Above formula (1) is explained more fully below in conjunction with FIG. 2.

In the case of a first through micropore 101 shown in FIG. 2A, when a circle 103 is drawn so as to be centered on the center of gravity of the first through micropore 101 and so as to be of the smallest radius that is internally tangent to the edge of another through micropore (inscribed in a second through micropore 102), the interior of the circle 3 includes the centers of gravity of six through micropores other than the first through micropore 101. Therefore, the first through micropore 101 is included in B.

In the case of another first through micropore 104 shown in FIG. 2B, when a circle 106 is drawn so as to be centered on the center of gravity of the first through micropore 104 and so as to be of the smallest radius that is internally tangent to the edge of another through micropore (inscribed in a second through micropore 105), the interior of the circle 106 includes the centers of gravity of five through micropores other than the first through micropore 104. Therefore, the first through micropore 104 is not included in B.

In the case of yet another first through micropore 107 shown in FIG. 2B, when a circle 109 is drawn so as to be centered on the center of gravity of the first through micropore 107 and so as to be of the smallest radius that is internally tangent to the edge of another through micropore (inscribed in a second through micropore 108), the interior of the circle 109 includes the centers of gravity of seven through micropores other than the first through micropore 107. Therefore, the first through micropore 107 is not included in B.

The insulating base 2 making up the microstructure 1 obtained by the method of the invention preferably has a thickness (as shown in FIG. 1B by the reference symbol 7) of from 30 to 300 $\mu$m, and more preferably from 50 to 100 $\mu$m. At an insulating base thickness within the foregoing range, the insulating base can be handled with ease.

Moreover, in the insulating base 2 making up the microstructure 1 obtained by the method of the invention, the width between the conductive paths 5 (i.e., width between the neighboring through micropores 3 filled with an electrically conductive material or portion represented in FIG. 1B by the reference symbol 8) is preferably at least 10 nm, more preferably from 20 to 100 nm, and even more preferably from 20 to 50 nm. At a width between the through micropores 3 of the insulating base filled with the electrically conductive within the foregoing range, the insulating base functions fully as an insulating barrier.

[Electrically Conductive Material]

In the microstructure 1 obtained by the method of the invention, the electrically conductive material to be filled into the through micropores 3 is not particularly limited as long as the material used has an electric resistivity of not more than $10^3$ $\Omega\cdot$cm. Illustrative examples of the electrically conductive material that may be preferably used include gold (Au), silver (Ag), copper (Cu), aluminum (Al), magnesium (Mg), and nickel (Ni).

Of these, in terms of electric conductivity, copper, gold, aluminum and nickel are preferred, copper and gold being more preferred.

In terms of cost, it is more preferable to use other materials than gold (e.g., copper) as the electrically conductive material to be filled into the through micropores 3 and to use gold only for forming the surfaces of the paths exposed at or protruded from both the surfaces of the insulating base 2 (hereinafter also referred to as "end faces").

In the microstructure 1 obtained by the method of the invention, all the through micropores 3 may be filled with the same or different electrically conductive materials. The front and back sides of each through micropore 3 may be filled with different electrically conductive materials.

In the microstructure 1 obtained by the method of the invention, the diameter of the conductive paths 5, (i.e., diameter of the through micropores 3 filled with the electrically conductive material or portion represented in FIG. 1B by the reference symbol 9) is preferably from 20 to 400 nm, more preferably from 40 to 200 nm, and even more preferably from 50 to 100 nm. At a diameter of the conductive paths within the foregoing range, when electrical signals are passed through the conductive paths, sufficient responses can be obtained, thus enabling more preferable use of the microstructure 1 obtained by the method of the invention as an inspection connector for electronic components.

In the microstructure 1 obtained by the method of the invention, when both the ends of the conductive path 5 protrude from both the surfaces 2a and 2b of the insulating base 2, that is, when the electrically conductive material filled into the through micropores 3 protrudes from both the surfaces of the insulating base 2, the protrusions (in FIG. 1B, the portions represented by the reference symbols 6a and 6b; also referred to below as "bumps") have a height of preferably from 1 to 100 nm, and more preferably from 5 to 50 nm. At a bump height in this range, connectivity with the electrode (pads) on an electronic component improves.

In the microstructure 1 obtained by the method of the invention, the conductive paths 5, that is, the through micropores 3 into which the electrically conductive material is filled are insulated from each other by the insulating base 2 and their density is at least $10^7$ micropores/mm$^2$, preferably at least $5 \times 10^7$ micropores/mm$^2$, and more preferably at least $10^8$ micropores/mm$^2$.

At a density of the through micropores 3 within the foregoing range, the microstructure of the invention can be used as inspection connectors and the like for electronic components such as semiconductor devices even today when still higher levels of integration have been achieved.

In the microstructure 1 obtained by the method of the invention, the center-to-center distance between neighboring conductive paths 5 (i.e., center-to-center distance between neighboring through micropores 3 or the portion represented in FIG. 1 by the reference symbol 10; also referred to below as the "pitch") is preferably from 20 to 500 nm, more preferably from 40 to 200 nm, and even more preferably from 50 to 140 nm. At a pitch in the foregoing range, a balance between the diameter of the conductive paths and the width between the conductive paths (insulating barrier thickness) is easily achieved.

In cases where the microstructure 1 obtained by the method of the invention is used as the anisotropic conductive member, as described above, it is preferred for the insulating base 2 to have a thickness of 30 to 300 $\mu$m, and for the conductive paths 5, that is, the through micropores 3 into which the electrically conductive material is filled to have a diameter of from 20 to 400 nm, because electrical conduction can be confirmed at a high density while keeping high insulating properties.

In cases where the microstructure 1 obtained by the method of the invention is used as the anisotropic conductive member, the through micropores 4 are preferably arrayed in a pattern as shown in FIG. 1 from the viewpoint that wiring of a desired pattern can be connected.

The through micropores 4 preferably have a diameter of 10 to 1000 nm, more preferably 20 to 850 nm and even more preferably 30 to 700 nm in terms of increasing the strength of the microstructure.

The microstructure which uses alumina for the base can be obtained by the inventive method of manufacturing microstructures to be described later. This method is also hereinafter referred to simply as the "inventive manufacturing method."

The invention provides a method of manufacturing a microstructure, wherein an aluminum substrate is subjected at least to, in order,

treatment (A) in which a micropore-bearing oxide film is formed by anodization;
treatment (B) in which aluminum is removed from the oxide film obtained by treatment (A);
treatment (C) in which part of the micropores present in the oxide film from which the aluminum has been removed by treatment (B) are made to extend through the oxide film;
treatment (D) in which the micropores which were made to extend through the oxide film by treatment (C) are filled with other material than the oxide film material; and a step (E) of surface planarization for removing bottoms of micropores of the oxide film that were not perforated in the treatment (C) to make the unperforated micropores extend through the oxide film, wherein, before performing the treatment (A), the surface of the aluminum substrate (12) is subjected to a mirror-like finishing treatment, and wherein, in order to perforate the part of the micropores present in the oxide film in the treatment (C), the treatment (C) comprises at least a treatment (C') which comprises forming a pattern which is insoluble or hardly soluble in an acid or an alkali on a surface of the oxide film after removal of the aluminum, and dissolving portions other than the pattern in the oxide film by using the acid or the alkali to make the micropores formed in the portions other than the pattern in the oxide film extend through the oxide film.

Next, an aluminum substrate that may be used in the inventive manufacturing method, and each treatment step carried out on the aluminum substrate are described in detail.

[Aluminum Substrate]

The aluminum substrate that may be used in the inventive manufacturing method is not subject to any particular limitation. Illustrative examples include pure aluminum plate; alloy plates composed primarily of aluminum and containing trace amounts of other elements; substrates made of low-purity aluminum (e.g., recycled material) on which high-purity aluminum has been vapor-deposited; substrates such as silicon wafers, quartz or glass whose surface has been covered with high-purity aluminum by a process such as vapor deposition or sputtering; and resin substrates on which aluminum has been laminated.

Of the aluminum substrate of the invention, the surface on which an anodized film is to be formed by the treatment (A) to be described below has an aluminum purity of preferably at least 99.5 wt%, more preferably at least 99.9 wt% and even more preferably at least 99.99 wt%. It is preferable for the aluminum purity to fall within the above range, because the array of the micropores is well ordered.

In the practice of the invention, the surface of the aluminum substrate on which the subsequently described treatment (A) is to be carried out is subjected beforehand to mirror-like finishing treatment, and preferably subjected to degreasing treatmant and mirror-like finishing treatment.

<Heat Treatment>

Heat treatment is preferably carried out at a temperature of from 200 to 350°C for a period of about 30 seconds to about 2 minutes. Such heat treatment improves the orderliness of the micropore array formed by the subsequently described treatment (A) .

Following heat treatment, it is preferable to rapidly cool the aluminum substrate. The method of cooling is exemplified by a method involving direct immersion of the aluminum substrate in water or the like.

<Degreasing Treatment>

Degreasing treatment is carried out with a suitable substance such as an acid, alkali or organic solvent so as to dissolve and remove organic substances, including dust, grease and resins, adhering to the aluminum substrate surface, and thereby prevent defects due to organic substances from arising in each of the subsequent treatments.

Preferred degreasing methods include the following: a method in which an organic solvent such as an alcohol (e.g., methanol), ketone (e.g., methyl ethyl ketone), petroleum benzin or volatile oil is contacted with the surface of the aluminum substrate at ambient temperature (organic solvent method); a method in which a liquid containing a surfactant such as soap or a neutral detergent is contacted with the surface of the aluminum substrate at a temperature of from ambient temperature to 80°C, after which the surface is rinsed with water (surfactant method); a method in which an aqueous sulfuric acid solution having a concentration of 10 to 200 g/L is contacted with the surface of the aluminum substrate at a temperature of from ambient temperature to 70°C for a period of 30 to 80 seconds, following which the surface is rinsed with water; a method in which an aqueous solution of sodium hydroxide having a concentration of 5 to 20 g/L is contacted with the surface of the aluminum substrate at ambient temperature for about 30 seconds while electrolysis is carried out by passing a direct current through the aluminum substrate surface as the cathode at a current density of 1 to 10 A/dm$^2$, following which the surface is contacted with an aqueous solution of nitric acid having a concentration of 100 to 500 g/L and thereby neutralized; a method in which any of various known anodizing electrolytic solutions is contacted with the surface of the aluminum substrate at ambient temperature while electrolysis is carried out by passing a direct current at a current density of 1 to 10 A/dm$^2$ through the aluminum substrate surface as the cathode or by passing an alternating current through the aluminum substrate surface as the cathode; a method in which an aqueous alkali solution having a concentration of 10 to 200 g/L is contacted with the surface of the aluminum substrate at 40 to 50°C for 15 to 60 seconds, following which an aqueous solution of nitric acid having a concentration of 100 to 500 g/L is contacted with the surface and thereby neutralized; a method in which an emulsion prepared by mixing a surfactant, water and the like into an oil such as gas oil or kerosene is contacted with the surface of the aluminum substrate at a temperature of from ambient temperature to 50°C, following which the surface is rinsed with water (emulsion degreasing method); and a method in which a mixed solution of, for example, sodium carbonate, phosphates and surfactant is contacted with the surface of the aluminum substrate at a temperature of from ambient temperature to 50°C for 30 to 180 seconds, following which the surface is rinsed with water (phosphate method).

Of these, the organic solvent method, surfactant method, emulsion degreasing method and phosphate method are preferred from the standpoint of removing grease from the aluminum surface while causing substantially no aluminum dissolution.

Known degreasers may be used in degreasing treatment. For example, degreasing treatment may be carried out using any of various commercially available degreasers by the prescribed method.

<Mirror-Like Finishing Treatment>

Mirror-like finishing treatment is carried out to eliminate surface asperities of the aluminum substrate and improve the uniformity and reproducibility of particle-forming treatment using, for example, electrodeposition. Exemplary surface asperities of the aluminum substrate include rolling streaks formed during rolling of the aluminum substrate which requires a rolling step for its manufacture.

In the practice of the invention, mirror-like finishing treatment is not subject to any particular limitation, and may be carried out using any suitable method known in the art. Examples of suitable methods include mechanical polishing, chemical polishing, and electrolytic polishing.

Illustrative examples of suitable mechanical polishing methods include polishing with various commercial abrasive cloths, and methods that combine the use of various commercial abrasives (e.g., diamond, alumina) with buffing. More specifically, a method which is carried out with an abrasive while changing over time the abrasive used from one having coarser particles to one having finer particles is appropriately illustrated. In such a case, the final abrasive used is preferably one having a grit size of 1500. In this way, a glossiness of at least 50% (in the case of rolled aluminum, at least 50% in both the rolling direction and the transverse direction) can be achieved.

Examples of chemical polishing methods include various methods mentioned in the 6th edition of Aluminum Handbook (Japan Aluminum Association, 2001), pp. 164-165.

Preferred examples include phosphoric acid/nitric acid method, Alupol I method, Alupol V method, Alcoa R5 method, $H_3PO_4$-$CH_3COOH$-Cu method and $H_3PO_4$-$HNO_3$-$CH_3COOH$ method. Of these, the phosphoric acid/nitric acid method, the $H_3PO_4$-$CH_3COOH$-Cu method and the $H_3PO_4$-$HNO_3$-$CH_3COOH$ method are especially preferred.

With chemical polishing, a glossiness of at least 70% (in the case of rolled aluminum, at least 70% in both the rolling direction and the transverse direction) can be achieved.

Examples of electrolytic polishing methods include various methods mentioned in the 6th edition of Aluminum Handbook (Japan Aluminum Association, 2001), pp. 164-165; the method described in US 2,708,655; and the method described in Jitsumu Hyomen Gijutsu (Practice of Surface Technology), Vol. 33, No. 3, pp. 32-38 (1986).

With electrolytic polishing, a glossiness of at least 70% (in the case of rolled aluminum, at least 70% in both the rolling direction and the transverse direction) can be achieved.

These methods may be suitably combined and used. In an illustrative method that may be preferably used, mechanical polishing which is carried out by changing the abrasive over time from one having coarser particles to one having finer particles is followed by electrolytic polishing.

Mirror-like finishing treatment enables a surface having, for example, a mean surface roughness $R_a$ of 0.1 $\mu$m or less and a glossiness of at least 50% to be obtained. The mean surface roughness $R_a$ is preferably 0.03 $\mu$m or less, and more preferably 0.02 $\mu$m or less. The glossiness is preferably at least 70%, and more preferably at least 80%.

The glossiness is the specular reflectance which can be determined in accordance with JIS Z8741-1997 (Method 3: 60° Specular Gloss) in a direction perpendicular to the rolling direction. Specifically, measurement is carried out using a variable-angle glossmeter (e.g., VG-1D, manufactured by Nippon Denshoku Industries Co., Ltd.) at an angle of incidence/reflection of 60° when the specular reflectance is 70% or less, and at an angle of incidence/reflection of 20° when the specular reflectance is more than 70%.

(A) Treatment in which a micropore-bearing oxide film is formed by anodization

In treatment (A), the aluminum substrate is anodized to form a micropore-bearing oxide film at the surface of the aluminum substrate.

Conventionally known methods may be used for anodizing treatment in the manufacturing method of the invention, but a self-ordering method to be described below is preferably used because the insulating base is an anodized film in an aluminum substrate which has micropores arrayed so as to have a degree of ordering as defined by formula (i) of preferably at least 50%.

The self-ordering method is a method which enhances the orderliness by using the regularly arranging nature of micropores in an anodized film and eliminating factors that may disturb an orderly arrangement. Specifically, an anodized film is formed on high-purity aluminum at a voltage appropriate for the type of electrolytic solution and at a low speed over an extended period of time (e.g., from several hours to well over ten hours).

In this method, because the micropore size is dependent on the voltage, to some degree it is possible to obtain the desired micropore size by controlling the voltage.

To form micropores by the self-ordering method, the subsequently described anodizing treatment (a) should be carried out. However, micropore formation is preferably carried out by a process in which the subsequently described anodizing treatment (a), film removal treatment (b) and re-anodizing treatment (c) are carried out in this order (self-ordering method I), or a process in which the subsequently described anodizing treatment (d) and oxide film dissolution treatment (e) are carried out in this order at least once (self-ordering method II).

Next, the respective treatments in the self-ordering method I and self-ordering method II in the preferred embodiments are described in detail.

[Self-Ordering Method I]

<Anodizing Treatment (a)>

The average flow velocity of electrolytic solution in anodizing treatment (a) is preferably from 0.5 to 20.0 m/min, more preferably from 1.0 to 15.0 m/min, and even more preferably from 2.0 to 10.0 m/min. By carrying out anodizing treatment (a) at the foregoing flow velocity, a uniform and high degree of ordering can be achieved.

The method for causing the electrolytic solution to flow under the above conditions is not subject to any particular limitation. For example, a method involving the use of a common agitator such as a stirrer may be employed. The use of a stirrer in which the stirring speed can be controlled with a digital display is particularly desirable because it enables the average flow velocity to be regulated. An example of such a stirrer is the Magnetic Stirrer HS-50D (manufactured by As One Corporation).

Anodizing treatment (a) may be carried out by, for example, a method in which current is passed through the aluminum substrate as the anode in a solution having an acid concentration of from 1 to 10 wt%.

The solution used in anodizing treatment (a) is preferably an acid solution. A solution of sulfuric acid, phosphoric acid, malonic acid, chromic acid, oxalic acid, sulfamic acid, benzenesulfonic acid, amidosulfonic acid, glycolic acid, tartaric acid, malic acid or citric acid is more preferred. Of these, a solution of sulfuric acid, phosphoric acid, oxalic acid or malonic acid is especially preferred. These acids may be used singly or as combinations of two or more thereof.

The anodizing treatment (a) conditions vary depending on the electrolytic solution employed, and thus cannot be strictly specified. However, the following conditions are generally preferred: an electrolytic solution concentration of from 0.1 to 20 wt%, a solution temperature of from -10 to 30°C, a current density of from 0.01 to 20 A/dm$^2$, a voltage of from 3 to 300 V, and an electrolysis time of from 0.5 to 30 hours. An electrolytic solution concentration of from 0.5 to 15 wt%, a solution temperature of from -5 to 25°C, a current density of from 0.05 to 15 A/dm$^2$, a voltage of from 5 to 250 V, and an electrolysis time of from 1 to 25 hours are more preferred. An electrolytic solution concentration of from 1 to 10 wt%, a solution temperature of from 0 to 20°C, a current density of from 0.1 to 10 A/dm$^2$, a voltage of from 10 to 200 V, and an electrolysis time of from 2 to 20 hours are even more preferred.

The treatment time in anodizing treatment (a) is preferably from 0.5 minute to 16 hours, more preferably from 1 minute to 12 hours, and even more preferably from 2 minutes to 8 hours.

Aside from being carried out at a constant voltage, anodizing treatment (a) may be carried out using a method in which the voltage is intermittently or continuously varied. In such cases, it is preferable to have the voltage gradually decrease. It is possible in this way to lower the resistance of the anodized film, bringing about the formation of small micropores in the anodized film. As a result, this approach is preferable for improving uniformity, particularly when sealing is subsequently carried out by electrodeposition treatment.

In the invention, the anodized film formed by such anodizing treatment (a) preferably has a thickness of 1 to 300 $\mu$m, more preferably 5 to 150 $\mu$m, and even more preferably 10 to 100 $\mu$m.

In the invention, the anodized film formed by such anodizing treatment (a) has an average micropore density of preferably from 50 to 1,500 micropores/$\mu$m$^2$.

It is preferable for the micropores to have a surface coverage of from 20 to 50%.

The surface coverage of the micropores is defined here as the ratio of the total surface area of the micropore openings to the surface area of the aluminum surface.

<Film Removal Treatment (b)>

In film removal treatment (b), the anodized film formed at the surface of the aluminum substrate by the above-described anodizing treatment (a) is dissolved and removed.

The subsequently described perforation step may be carried out immediately after forming an anodized film at the surface of the aluminum substrate by the above-described anodizing treatment (a). However, after the anodizing treatment (a), it is preferable to additionally carry out film removal treatment (b) and the subsequently described re-anodizing treatment (c) in this order, followed by the subsequently described perforation step.

Given that the orderliness of the anodized film increases as the aluminum substrate is approached, by using this film removal treatment (b) to remove the anodized film that has been formed in (a), the lower portion of the anodized film remaining at the aluminum substrate emerges at the surface, affording an orderly array of pits. Therefore, in film removal treatment (b), aluminum is not dissolved; only the anodized film composed of alumina (aluminum oxide) is dissolved.

The alumina dissolving solution is preferably an aqueous solution containing at least one substance selected from the group consisting of chromium compounds, nitric acid, phosphoric acid, zirconium compounds, titanium compounds, lithium salts, cerium salts, magnesium salts, sodium hexafluorosilicate, zinc fluoride, manganese compounds, molybdenum compounds, magnesium compounds, barium compounds, and uncombined halogens.

Illustrative examples of chromium compounds include chromium (III) oxide and chromium (VI) oxide.

Examples of zirconium compounds include zirconium ammonium fluoride, zirconium fluoride and zirconium chloride.

Examples of titanium compounds include titanium oxide and titanium sulfide.

Examples of lithium salts include lithium fluoride and lithium chloride.

Examples of cerium salts include cerium fluoride and cerium chloride.

Examples of magnesium salts include magnesium sulfide.

Examples of manganese compounds include sodium permanganate and calcium permanganate.

Examples of molybdenum compounds include sodium molybdate.

Examples of magnesium compounds include magnesium fluoride pentahydrate.

Examples of barium compounds include barium oxide, barium acetate, barium carbonate, barium chlorate, barium chloride, barium fluoride, barium iodide, barium lactate, barium oxalate, barium perchlorate, barium selenate, barium selenite, barium stearate, barium sulfite, barium titanate, barium hydroxide, barium nitrate, and hydrates thereof.

Of the above barium compounds, barium oxide, barium acetate and barium carbonate are preferred. Barium oxide is especially preferred.

Examples of uncombined halogens include chlorine, fluorine and bromine.

Of the above, the alumina dissolving solution is preferably an acid-containing aqueous solution. Examples of the acid include sulfuric acid, phosphoric acid, nitric acid and hydrochloric acid. A mixture of two or more acids is also acceptable.

The acid concentration is preferably at least 0.01 mol/L, more preferably at least 0.05 mol/L, and even more preferably at least 0.1 mol/L. Although there is no particular upper limit in the acid concentration, in general, the concentration is preferably 10 mol/L or less, and more preferably 5 mol/L or less. A needlessly high concentration is uneconomical, in addition to which higher concentrations may result in dissolution of the aluminum substrate.

The alumina dissolving solution has a temperature of preferably -10°C or higher, more preferably -5°C or higher, and even more preferably 0°C or higher. Carrying out treatment using a boiling alumina dissolving solution destroys or disrupts the starting points for ordering. Hence, the alumina dissolving solution is preferably used without being boiled.

An alumina dissolving solution dissolves alumina, but does not dissolve aluminum. Here, the alumina dissolving solution may dissolve a very small amount of aluminum, so long as it does not dissolve a substantial amount of aluminum.

Film removal treatment (b) is carried out by bringing an aluminum substrate at which an anodized film has been formed into contact with the above-described alumina dissolving solution. Examples of the contacting method include, but are not limited to, immersion and spraying. Of these, immersion is preferred.

Immersion is a treatment in which the aluminum substrate at which an anodized film has been formed is immersed in the alumina dissolving solution. To achieve uniform treatment, it is desirable to carry out stirring at the time of immersion treatment.

The immersion treatment time is preferably at least 10 minutes, more preferably at least 1 hour, even more preferably at least 3 hours, and most preferably at least 5 hours.

<Re-Anodizing Treatment (c)>

An anodized film having micropores with an even higher degree of ordering can be formed by carrying out anodizing treatment once again after the anodized film is removed by the film removal treatment (b) to form well-ordered pits on the surface of the aluminum substrate.

Re-anodizing treatment (c) may be carried out using a method known in the art, although it is preferably carried out under the same conditions as the above-described anodizing treatment (a).

Alternatively, suitable use may be made of a method in which the current is repeatedly turned on and off while keeping the dc voltage constant, or a method in which the current is repeatedly turned on and off while intermittently varying the dc voltage. Because these methods result in the formation of small micropores in the anodized film, they are preferable for improving uniformity, particularly when sealing is to be carried out by electrodeposition treatment.

When re-anodizing treatment (c) is carried out at a low temperature, the array of micropores is well-ordered and the pore size is uniform.

On the other hand, by carrying out re-anodizing treatment (c) at a relatively high temperature, the micropore array may be disrupted or the variance in pore size may be set within a given range. The variance in pore size may also be controlled by means of the treatment time.

In the practice of the invention, the anodized film formed by such re-anodizing treatment (c) has a thickness of preferably from 30 to 1,000 $\mu$m, and more preferably from 50 to 500 $\mu$m.

Moreover, in the invention, the micropores formed in the anodized film by such re-anodizing treatment (c) have a diameter of preferably from 0.01 to 0.5 $\mu$m and more preferably from 0.02 to 0.1 $\mu$m.

The average micropore density is at least $10^7$ micropores/mm$^2$.

In the self-ordering method I, in place of the above-described anodizing treatment (a) and film removal treatment (b), use may be made of, for example, a physical method, a particle beam method, a block copolymer method or a resist patterning/exposure/etching process to form pits as starting points for micropore formation by the above-described re-anodizing treatment (c).

<Physical Method>

Physical methods are exemplified by methods which use imprinting (transfer methods and press patterning methods in which a plate or roll having projections thereon is pressed against the aluminum substrate to form depressions on the substrate). A specific example is a method in which a plate having numerous projections on a surface thereof is pressed against the aluminum surface, thereby forming depressions. For example, the method described in JP 10-121292 A may be used.

Another example is a method in which polystyrene spheres are densely arranged on the aluminum surface, $SiO_2$ is vapor-deposited onto the spheres, then the polystyrene spheres are removed and the substrate is etched using the vapor-deposited $SiO_2$ as the mask, thereby forming depressions.

<Particle Beam Method>

In a particle beam method, depressions are formed by irradiating the aluminum surface with a particle beam. This method has the advantage that the positions of the depressions can be freely controlled.

Examples of the particle beam include a charged particle beam, a focused ion beam (FIB), and an electron beam.

An example of the particle beam method that may be used is the method described in JP 2001-105400 A.

<Block Copolymer Method>

The block copolymer method involves forming a block copolymer layer on the aluminum surface, forming an islands-in-the-sea structure in the block copolymer layer by thermal annealing, then removing the island components to form depressions.

An example of the block copolymer method that may be used is the method described in JP 2003-129288 A.

<Resist Patterning/Exposure/Etching Process>

In a resist patterning/exposure/etching process, resist on the surface of an aluminum plate is exposed and developed by photolithography or electron-beam lithography to form a resist pattern. The resist is then etched, forming depressions which pass entirely through the resist to the aluminum surface.

[Self-Ordering Method II]

<First Step: Anodizing Treatment (d)>

Conventionally known electrolytic solutions may be used in anodizing treatment (d) but the orderliness of the pore array can be considerably improved by carrying out, under conditions of direct current and constant voltage, anodization using an electrolytic solution in which the parameter R represented by general formula (ii) wherein A is the film-forming rate during application of current and B is the film dissolution rate during non-application of current satisfies $160 \leq R \leq 200$, preferably $170 \leq R \leq 190$ and most particularly $175 \leq R \leq 185$.

$$R = A \ [nm/s] \ / \ (B \ [nm/s] \ \times \ voltage \ applied \ [V]) \ \cdots (ii)$$

As in the above-described anodizing treatment (a), the average flow velocity of electrolytic solution in anodizing treatment (d) is preferably from 0.5 to 20.0 m/min, more preferably from 1.0 to 15.0 m/min, and even more preferably from 2.0 to 10.0 m/min. By carrying out anodizing treatment (d) at the foregoing flow velocity, a uniform and high degree of ordering can be achieved.

As in the above-described anodizing treatment (a), the method for causing the electrolytic solution to flow under the above conditions is not subject to any particular limitation. For example, a method involving the use of a common agitator such as a stirrer may be employed. The use of a stirrer in which the stirring speed can be controlled with a digital display is particularly desirable because it enables the average flow velocity to be regulated. An example of such a stirrer is the Magnetic Stirrer HS-50D (manufactured by As One Corporation).

The anodizing treatment solution preferably has a viscosity at 25°C and 1 atm of 0.0001 to 100.0 Pa·s and more preferably 0.0005 to 80.0 Pa·s. By carrying out anodizing treatment (d) using the electrolytic solution having the foregoing viscosity, a uniform and high degree of ordering can be achieved.

The electrolytic solution used in anodizing treatment (d) may be an acidic solution or an alkaline solution, but an acidic electrolytic solution is advantageously used in terms of improving the circularity of the pores.

More specifically, as in the above-described anodizing treatment (a), a solution of hydrochloric acid, sulfuric acid, phosphoric acid, chromic acid, oxalic acid, glycolic acid, tartaric acid, malic acid, citric acid, sulfamic acid, benzenesulfonic acid, amidosulfonic acid, glycolic acid, tartaric acid, malic acid, or citric acid is more preferred. Of these, a solution of sulfuric acid, phosphoric acid or oxalic acid is especially preferred. These acids may be used singly or as combinations of two or more thereof by adjusting the parameter in the calculating formula represented by general formula (ii) as desired.

The anodizing treatment (d) conditions vary depending on the electrolytic solution employed, and thus cannot be strictly specified. However, as in the above-described anodizing treatment (a), the following conditions are generally preferred: an electrolytic solution concentration of from 0.1 to 20 wt%, a solution temperature of from -10 to 30°C, a current density of from 0.01 to 20 A/dm$^2$, a voltage of from 3 to 500 V, and an electrolysis time of from 0.5 to 30 hours. An electrolytic solution concentration of from 0.5 to 15 wt%, a solution temperature of from -5 to 25°C, a current density of from 0.05 to 15 A/dm$^2$, a voltage of from 5 to 250 V, and an electrolysis time of from 1 to 25 hours are more preferred. An electrolytic solution concentration of from 1 to 10 wt%, a solution temperature of from 0 to 20°C, a current density of from 0.1 to 10 A/dm$^2$, a voltage of from 10 to 200 V, and an electrolysis time of from 2 to 20 hours are even more preferred.

In the practice of the invention, the anodized film formed by such anodizing treatment (d) has a thickness of preferably from 0.1 to 300 $\mu$m, more preferably from 0.5 to 150 $\mu$m and even more preferably from 1 to 100 $\mu$m.

In the invention, the anodized film formed by such anodizing treatment (d) has an average micropore density of preferably from 50 to 1,500 micropores/$\mu$m$^2$.

It is preferable for the micropores to have a surface coverage of from 20 to 50%.

The surface coverage of the micropores is defined here as the ratio of the total surface area of the micropore openings to the surface area of the aluminum surface.

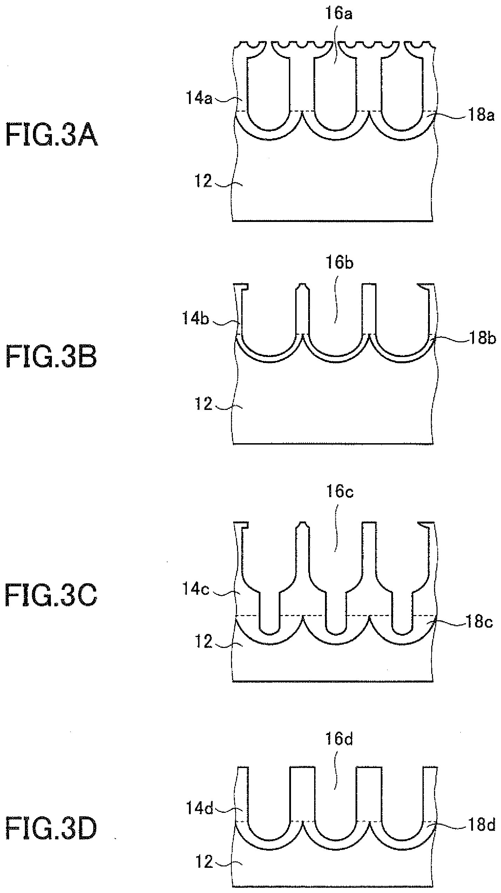

As shown in FIG. 3A, as a result of anodizing treatment (d), an anodized film 14a bearing micropores 16a is formed at a surface of an aluminum substrate 12. A barrier layer 18a is present on the side of the aluminum substrate 12 from the anodized film 14a.

<Second Step: Oxide Film Dissolution Treatment (e) >

Oxide film dissolution treatment (e) is a treatment for enlarging the diameter of the micropores present in the anodized film formed by the above-described anodizing treatment (d) (pore diameter). This treatment is also referred to as pore diameter enlarging treatment.

Oxide film dissolution treatment (e) is carried out by bringing the aluminum substrate having undergone the above-described anodizing treatment (d) into contact with the aqueous acid or alkali solution. Examples of the contacting method include, but are not limited to, immersion and spraying. Of these, immersion is preferred.

When oxide film dissolution treatment (e) is to be performed with an aqueous acid solution, it is preferable to use an aqueous solution of an inorganic acid such as sulfuric acid, phosphoric acid, nitric acid or hydrochloric acid, or a mixture thereof. It is particularly preferable to use an aqueous solution containing no chromic acid in terms of its high degree of safety. The aqueous acid solution preferably has a concentration of 1 to 10 wt%. The aqueous acidic solution preferably has a temperature of 25 to 60°C.

When oxide film dissolution treatment (e) is to be performed with an aqueous alkali solution, it is preferable to use an aqueous solution of at least one alkali selected from the group consisting of sodium hydroxide, potassium hydroxide and lithium hydroxide. The aqueous alkali solution preferably has a concentration of 0.1 to 5 wt%. The aqueous alkali solution preferably has a temperature of 20 to 35°C.

Specific examples of preferred solutions include a 40°C aqueous solution containing 50 g/L of phosphoric acid, a 30°C aqueous solution containing 0.5 g/L of sodium hydroxide, and a 30°C aqueous solution containing 0.5 g/L of potassium hydroxide.

The time of immersion in the aqueous acid solution or aqueous alkali solution is preferably from 8 to 120 minutes, more preferably from 10 to 90 minutes and even more preferably from 15 to 60 minutes.

In the oxide film dissolution treatment (e), the amount of enlargement of the pore diameter vary with the conditions of anodizing treatment (d) but the ratio of after to before the treatment is preferably 1.05 to 100, more preferably 1.1 to 75 and even more preferably 1.2 to 50.

Oxide film dissolution treatment (e) dissolves the surface of the anodized film 14a and the interiors of the micropores 16a (barrier layer 18a) as shown in FIG. 3A to obtain an aluminum member having a micropore 16b-bearing anodized film 14b on the aluminum substrate 12 as shown in FIG. 3B. As in FIG. 3A, a barrier layer 18b is present on the side of the aluminum substrate 12 from the anodized film 14b.

<Third Step: Anodizing Treatment (d) >

In the self-ordering method II, it is preferred to carry out the above-described anodizing treatment (d) again after the above-described oxide film dissolution treatment (e).

By carrying out anodizing treatment (d) again, oxidation reaction of the aluminum substrate 12 shown in FIG. 3B proceeds to obtain, as shown in FIG. 3C, an aluminum member which has an anodized film 14c formed on the aluminum substrate 12, the anodized film 14c bearing micropores 16c having a larger depth than the micropores 16b. As in FIG. 3A, a barrier layer 18c is present on the side of the aluminum substrate 12 from the anodized film 14c.

<Fourth Step: Oxide Film Dissolution Treatment (e) >

In the self-ordering method II, it is preferred to further carry out the above-described oxide film dissolution treatment (e) after the above-described anodizing treatment (d), oxide film dissolution treatment (e) and anodizing treatment (d) have been carried out in this order.

This treatment enables the treatment solution to enter the micropores to dissolve all the film formed by anodizing treatment (d) in the third step, whereby the micropores formed by anodizing treatment (d) in the third step may have enlarged diameters.

More specifically, oxide film dissolution treatment (e) carried out again dissolves the interiors of the micropores 16c on the surface side from inflection points in the anodized film 14c shown in FIG. 3C to obtain an aluminum member having an anodized film 14d bearing straight tube-shaped micropores 16d on the aluminum substrate 12 as shown in FIG. 3D. As in FIG. 3A, a barrier layer 18d is present on the side of the aluminum substrate 12 from the anodized film 14d.

The amount of enlargement of the pore diameter of the micropores vary with the treatment conditions in anodizing treatment (d) carried out in the third step but the ratio of after to before the treatment is preferably 1.05 to 100, more preferably 1.1 to 75 and even more preferably 1.2 to 50.

The self-ordering method II involves at least one cycle of the above-described anodizing treatment (d) and oxide film dissolution treatment (e). The larger the number of repetitions is, the more the degree of ordering of the pore array is increased.

The circularity of the micropores seen from the film surface is dramatically improved by dissolving in oxide film dissolution treatment (e) all the anodized film formed by the preceding anodizing treatment (d). Therefore, this cycle is preferably repeated at least twice, more preferably at least three times and even more preferably at least four times.

In cases where this cycle is repeated at least twice, the conditions in each cycle of oxide film dissolution treatment and anodizing treatment may be the same or different. Alternatively, the treatment may be terminated by anodizing treatment.

(B) Treatment in which aluminum is removed from the oxide film obtained by treatment (A)

Treatment (B) dissolves and removes the aluminum substrate from the oxide film obtained by the above-described treatment (A). A treatment solution which does not readily dissolve the anodized film (alumina) but readily dissolves aluminum is used for dissolution of the aluminum substrate.

That is, use is made of a treatment solution which has an aluminum dissolution rate of at least 1 $\mu$m/min, preferably at least 3 $\mu$m/min, and more preferably at least 5 $\mu$m/min, and has an anodized film dissolution rate of 0.1 nm/min or less, preferably 0.05 nm/min or less, and more preferably 0.01 nm/min or less.

Specifically, a treatment solution which includes at least one metal compound having a lower ionization tendency than aluminum, and which has a pH of 4 or less or 8 or more, preferably 3 or less or 9 or more, and more preferably 2 or less or 10 or more is used for immersion treatment.

Preferred examples of such treatment solutions include solutions which are composed of, as the base, an aqueous solution of an acid or an alkali and which have blended therein a compound of, for example, manganese, zinc, chromium, iron, cadmium, cobalt, nickel, tin, lead, antimony, bismuth, copper, mercury, silver, palladium, platinum or gold (e.g., chloroplatinic acid), or a fluoride or chloride of any of these metals.

Of the above, it is preferable for the treatment solution to be based on an aqueous solution of an acid and to have blended therein a chloride compound.

Treatment solutions of an aqueous solution of hydrochloric acid in which mercury chloride has been blended (hydrochloric acid/mercury chloride), and treatment solutions of an aqueous solution of hydrochloric acid in which copper chloride has been blended (hydrochloric acid/copper chloride) are especially preferred from the standpoint of the treatment latitude.

There is no particular limitation on the composition of such treatment solutions. Illustrative examples of the treatment solutions include a bromine/methanol mixture, a bromine/ethanol mixture, and aqua regia.

Such a treatment solution preferably has an acid or alkali concentration of 0.01 to 10 mol/L and more preferably 0.05 to 5 mol/L.

In addition, such a treatment solution is used at a treatment temperature of preferably -10°C to 80°C and more preferably 0 to 60°C.

In the practice of the invention, dissolution of the aluminum substrate is carried out by bringing the aluminum substrate having undergone the above-described anodizing treatment step into contact with the above-described treatment solution. Examples of the contacting method include, but are not limited to, immersion and spraying. Of these, immersion is preferred. The period of contact at this time is preferably from 10 seconds to 5 hours, and more preferably from 1 minute to 3 hours.

(C) Treatment in which part of the micropores present in the oxide film from which the aluminum has been removed by treatment (B) are made to extend through the oxide film

Part of the micropores present in the oxide film from which the aluminum substrate has been removed by treatment (B) is subjected to treatment (C) to remove only the bottoms of the part of the micropores in the oxide film to make the part of the micropores present in the oxide film extend therethrough. This treatment is carried out by bringing only the bottoms of the micropores to be perforated in the oxide film into contact with an aqueous acid solution or an aqueous alkali solution. Removal of the bottoms of the micropores in the oxide film causes the micropores to extend therethrough.

A specific method that may be used involves forming a pattern which is insoluble or hardly soluble in an acid or an alkali on a surface of the oxide film after removal of aluminum, and dissolving and removing the bottoms of portions other than the pattern in the oxide film by using the acid or the alkali to make the micropores extend through the oxide film.

More specifically, a method that may be preferably used involves forming a photosensitive layer or a thermosensitive layer on a surface of the oxide film after removal of aluminum, forming a pattern by exposure to light or heat, and dissolving other portions than the pattern of the oxide film by using an acid or an alkali. Use of an alkali is preferred because a better pattern is obtained. Preferred examples are shown below.

<Formation of Alkali-Developable Thermosensitive Layer/Photosensitive Layer>

In the practice of the invention, the alkali-soluble resin contained as the thermosensitive layer/photosensitive layer are not particularly limited and any of a monolayer type, a phase-separated type and a multilayer type may be formed.

The alkali soluble resins can be used for the monolayer type recording layers such as the photosensitive layers described in JP 7-285275 A and WO 97/39894, phase-separated type recording layers such as the photosensitive layer described in JP 11-44956 A, and multilayer type recording layers such as the photosensitive layers described in JP 11-218914 A, US 6352812B1, US 6352811B1, US 6358669 B1, US 6534238B1 and EP 864420B1, but are not limited thereto.

Illustrative examples of the negative resin composition that may be advantageously used include negative photosensitive resin compositions using diazonium salts as described in paragraphs [0006] to [0019] of JP 5-197137 A; photopolymerizable compositions as described in paragraphs [0055] to [0134] of JP 8-320551 A; and photopolymerizable compositions as described in paragraphs [0007] to [0063] of JP 10-195119 A.

<Perforating Treatment>

The bottom of the oxide film is preferably removed by the method that involves previously immersing the oxide film in a pH buffer solution to fill the micropores with the pH buffer solution from the micropore opening side, and bringing the surface opposite from the openings (i.e., the bottom of the oxide film) into contact with an aqueous acid solution or aqueous alkali solution.

When this treatment is to be carried out with an aqueous acid solution, it is preferable to use an aqueous solution of an inorganic acid such as sulfuric acid, phosphoric acid, nitric acid or hydrochloric acid, or a mixture thereof. The aqueous acid solution preferably has a concentration of 1 to 10 wt%. The aqueous acid solution preferably has a temperature of 25 to 40°C.

When this treatment is to be carried out with an aqueous alkali solution, it is preferable to use an aqueous solution of at least one alkali selected from the group consisting of sodium hydroxide, potassium hydroxide and lithium hydroxide. The aqueous alkali solution preferably has a concentration of 0.1 to 5 wt%. The aqueous alkali solution preferably has a temperature of 20 to 35°C.

Specific examples of preferred solutions include a 40°C aqueous solution containing 50 g/L of phosphoric acid, a 30°C aqueous solution containing 0.5 g/L of sodium hydroxide, and a 30°C aqueous solution containing 0.5 g/L of potassium hydroxide.

The time of immersion in the aqueous acid solution or aqueous alkali solution is preferably from 8 to 120 minutes, more preferably from 10 to 90 minutes and even more preferably from 15 to 60 minutes.

In cases where the film is previously immersed in a pH buffer solution, a buffer solution suitable to the foregoing acids/alkalis is used.

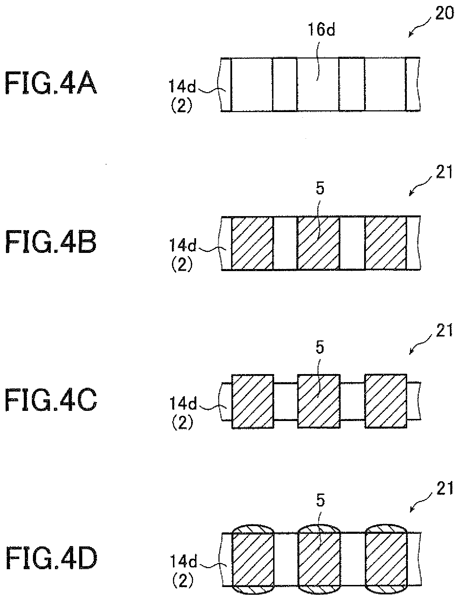

This perforating treatment yields a structure shown in FIG. 3D after removal of the aluminum substrate 12 and the barrier layer 18d, that is, an insulating base 20 having through micropores 16d as shown in FIG. 4A. FIG. 4A shows only part of the insulating base where micropores 16d are made to extend through the insulating base by treatment (C). The same holds true for FIGS. 4B to 4D.

(D) Treatment for filling a different material from the oxide film material into the micropores that were made to extend through by treatment (C)

In treatment (D), a different material from the oxide film material is filled into the micropores that were made to extend through by treatment (C), that is, through micropores. In cases where the microstructure of the invention is used as an anisotropic conductive member, a metal which is an electrically conductive material is filled into the through micropores. The electrically conductive material to be filled makes up the conductive paths of an anisotropic conductive member as described in connection with the microstructure of the invention.

In the inventive manufacturing method, an electrolytic plating process or an electroless plating process may be used for the metal filling method.

In a conventionally known electrolytic plating process that is used for coloring or other purposes, it is difficult to selectively deposit (grow) metal inside through micropores at a high aspect ratio, presumably because the deposited metal is consumed within the through micropores and the plating does not grow even when electrolysis is carried out for at least a fixed period of time.

Therefore, in the inventive manufacturing method, when metal filling is carried out by electrolytic plating, it is necessary to provide rest periods during pulse electrolysis or constant potential electrolysis. The rest periods must be at least 10 seconds, and are preferably from 30 to 60 seconds.

To promote stirring of the electrolytic solution, it is desirable to apply ultrasound energy.

Moreover, the electrolysis voltage is generally not more than 20 V, and preferably not more than 10 V, although it is preferable to first measure the deposition potential of the target metal in the electrolytic solution to be used and carry out constant potential electrolysis at that potential + not more than 1V. When carrying out constant potential electrolysis, it is desirable to use also cyclic voltammetry. To this end, use may be made of potentiostats such as those available from Solartron, BAS, Hokuto Denko and Ivium.

Plating may be carried out using a plating solution known in the art.

More specifically, when copper is to be deposited, an aqueous solution of copper sulfate may generally be used. The concentration of copper sulfate is preferably from 1 to 300 g/L, and more preferably from 100 to 200 g/L. Deposition can be promoted by adding hydrochloric acid to the electrolytic solution. In such a case, the concentration of hydrochloric acid is preferably from 10 to 20 g/L.

When gold is to be deposited, it is desirable to carry out plating by alternating current electrolysis using a sulfuric acid solution of a tetrachloroaurate.

According to the electroless plating process, it takes much time to completely fill the through micropores having a high aspect ratio with a metal and it is therefore desirable to fill the metal by the electrolytic plating process in the inventive manufacturing method.

This metal filling treatment yields a microstructure 21 having the conductive paths 5 shown in FIG. 4B as obtained by filling the through micropores with a metal.

[Surface Planarization]

In the inventive manufacturing method, the above-described treatment (D) is preferably followed by chemical mechanical polishing to carry out surface planarization whereby the front side and the back side are planarized.

By carrying out chemical mechanical polishing (CMP), the front and back sides of the microstructure after the through micropores have been filled with other material than the oxide film material can be planarized while removing excess material adhering to the surfaces after filling. Through this treatment, the bottoms of the micropores which could not be passed through the oxide film by treatment (C) are removed so that the micropores which were not filled with other material than the oxide film material by treatment (D) extend through the oxide film, thereby forming through micropores which are not filled with other material than the oxide film material.

CMP treatment may be carried out by using a CMP slurry such as PNANERLITE-7000 (available from Fujimi Inc.), GPX HSC800 produced by Hitachi Chemical Co., Ltd., or CL-1000 produced by AGC Seimi Chemical Co., Ltd.

It is not preferred to use a slurry for interlayer dielectric films and barrier metals, because the anodized film should not be polished.

In addition to the CMP treatment, ion milling treatment or electrolytic polishing treatment may be carried out for surface planarization.

[Trimming]

In cases where the microstructure is used as an anisotropic conductive member, trimming is preferably carried out after the above-described treatment (D) (after the above-described surface planarization in cases where this treatment was carried out).

Trimming is a treatment in which only part of the insulating base is removed from the surface of the microstructure having undergone treatment (D) (having undergone the above-described surface planarization in cases where this treatment was carried out) to protrude the metal filled into the through micropores from the insulating substrate surface.

Trimming treatment can be performed under the same treatment conditions as those of the above-described oxide film dissolution treatment (e) provided a metal making up the conductive paths is not dissolved. It is particularly preferred to use phosphoric acid with which the dissolution rate is readily controlled.

This trimming step yields the microstructure 21 as shown in FIG. 4C which has the conductive paths 5 protruded from the insulating substrate, surfaces.

In the inventive manufacturing method, the above-described trimming may be replaced by electrodeposition in which a conductive metal which is the same as or different from the one filled into the through micropores is further deposited only on the surfaces of the conductive paths 5 shown in FIG. 4B (FIG. 4D) .

[Protective Film-Forming Treatment]

In the inventive manufacturing method, the micropore size changes with time by the hydration of the insulating base made of alumina with moisture in the air and therefore a protective film-forming treatment is preferably carried out before treatment (D).

Illustrative examples of protective films include inorganic protective films containing elemental zirconium and/or elemental silicon, and organic protective films containing a water-insoluble polymer.

The method of forming an elemental zirconium-containing protective film is not subject to any particular limitation, although a commonly used method of treatment involves direct immersion in an aqueous solution in which a zirconium compound is dissolved. From the standpoint of the strength and stability of the protective film, the use of an aqueous solution in which a phosphorus compound has also been dissolved is preferred.

Illustrative examples of the zirconium compound that may be used include zirconium, zirconium fluoride, sodium hexafluorozirconate, calcium hexafluorozirconate, zirconium fluoride, zirconium chloride, zirconium oxychloride, zirconium oxynitrate, zirconium sulfate, zirconium ethoxide, zirconium propoxide, zirconium butoxide, zirconium acetylacetonate, tetrachlorobis (tetrahydrofuran)zirconium, bis(methylcyclopentadienyl)zirconium dichloride, dicyclopentadienylzirconium dichloride and ethylenebis(indenyl)zirconium (IV) dichloride. Of these, sodium hexafluorozirconate is preferred.

From the standpoint of the uniformity of the protective film thickness, the concentration of the zirconium compound in the aqueous solution is preferably from 0.01 to 10 wt%, and more preferably from 0.05 to 5 wt%.

Illustrative examples of the phosphorus compound that may be used include phosphoric acid, sodium phosphate, calcium phosphate, sodium hydrogen phosphate and calcium hydrogen phosphate. Of these, sodium hydrogen phosphate is preferred.

From the standpoint of the uniformity of the protective film thickness, the concentration of the zirconium compound in the aqueous solution is preferably from 0.1 to 20 wt%, and more preferably from 0.5 to 10 wt%.

The treatment temperature is preferably from 0 to 120°C, and more preferably from 20 to 100°C.

The method of forming a protective film containing elemental silicon is not subject to any particular limitation, although a commonly used method of treatment involves direct immersion in an aqueous solution in which an alkali metal silicate is dissolved. The thickness of the protective film can be adjusted by varying the ratio between the silicate ingredients silicon dioxide $SiO_2$ and alkali metal oxide $M_2O$ (generally represented as the molar ratio $[SiO_2]/[M_2O]$) and the concentrations thereof in the aqueous solution of an alkali metal silicate.

It is especially preferable here to use sodium or potassium as M.

The molar ratio $[SiO_2]/[M_2O]$ is preferably from 0.1 to 5.0, and more preferably from 0.5 to 3.0.

The $SiO_2$ content is preferably from 0.1 to 20 wt%, and more preferably from 0.5 to 10 wt%.

The organic protective film is preferably obtained by a method which involves direct immersion in an organic solvent in which a water-insoluble polymer is dissolved, followed by heating treatment to evaporate off only the solvent.

Illustrative examples of the water-insoluble polymer include polyvinylidene chloride, poly(meth)acrylonitrile, polysulfone, polyvinyl chloride, polyethylene, polycarbonate, polystyrene, polyamide and cellophane.

Illustrative examples of the organic solvent include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone and toluene.

The concentration is preferably from 0.1 to 50 wt%, and more preferably from 1 to 30 wt%.

The heating temperature during solvent evaporation is preferably from 30 to 300°C, and more preferably from 50 to 200°C.

Following protective film-forming treatment, the anodized film including the protective film has a thickness of preferably from 0.1 to 100 μm, and more preferably from 1 to 500 μm.

In the inventive manufacturing method, the hardness and the heat cycle resistance can be controlled by carrying out heating treatment depending on the application of the microstructure obtained.

For example, the heating temperature is preferably at least 100°C, more preferably at least 200°C and even more preferably at least 400°C. The heating time is preferably from 10 seconds to 24 hours, more preferably from 1 minute to 12 hours and even more preferably from 30 minutes to 8 hours. Such heating treatment improves the hardness while suppressing the expansion and contraction during the heat cycle of heating and cooling in the semiconductor manufacturing step.

EXAMPLES

(Example 1)

(A) Mirror-Like Finishing Treatment (Electrolytic Polishing)

A high-purity aluminum substrate (Sumitomo Light Metal Industries, Ltd.; purity, 99.99 wt%; thickness, 0.4 mm) was cut to a size of 10 cm square that allows it to be anodized, then subjected to electrolytic polishing using an electrolytic polishing solution of the composition indicated below at a voltage of 25 V, a solution temperature of 65°C, and a solution flow velocity of 3.0 m/min.

A carbon electrode was used as the cathode, and a GP0110-30R unit (Takasago, Ltd.) was used as the power supply. In addition, the flow velocity of the electrolytic solution was measured using the vortex flow monitor FLM22-10PCW manufactured by As One Corporation.

(Electrolytic Polishing Solution Composition)

| | |
|---|---|
| 85 wt% Phosphoric acid (Wako Pure Chemical Industries, Ltd.) | 660 mL |
| Pure water | 160 mL |
| Sulfuric acid | 150 mL |
| Ethylene glycol | 30 mL |

(B) Anodizing Treatment (Self-Ordering Method I)

After electrolytic polishing, the aluminum substrate was subjected to 5 hours of preliminary anodizing treatment with an electrolytic solution of 0.30 mol/L sulfuric acid under the following conditions: voltage, 25 V; solution temperature, 15°C; solution flow velocity, 3.0 m/min.

After preliminary anodizing treatment, the aluminum substrate was subjected to film removal treatment in which it was immersed for 12 hours in a mixed aqueous solution (solution temperature, 50°C) of 0.2 mol/L chromic anhydride and 0.6 mol/L phosphoric acid.

Next, the aluminum substrate was subjected to 1 hour of re-anodizing treatment with an electrolytic solution of 0.30 mol/L sulfuric acid under the following conditions: voltage, 25 V; solution temperature, 15°C; solution flow velocity, 3.0 m/min.

Preliminary anodizing treatment and re-anodizing treatment were both carried out using a stainless steel electrode as the cathode and using a GP0110-30R unit (Takasago, Ltd.) as the power supply. In addition, use was made of NeoCool BD36 (Yamato Scientific Co., Ltd.) as the cooling system, and Pairstirrer PS-100 (Tokyo Rikakikai Co., Ltd.) as the stirring and warming unit. In addition, the flow velocity of the electrolytic solution was measured using the vortex flow monitor FLM22-10PCW (As One Corporation).

(C) Aluminum Removal Treatment

Next, the aluminum substrate was dissolved by 3 hours of immersion at 20°C in a 20 wt% aqueous solution of mercuric chloride (corrosive sublimate).

(D) Heating Treatment

Next, the structure obtained as above was then subjected to one hour of heating treatment at a temperature of 400°C.

(E) Photosensitive Layer-Forming Treatment

Next, the surface of the structure obtained as above from which aluminum had been removed was coated with a photosensitive layer-forming coating solution A of the composition indicated below by a wire bar and dried for 50 seconds in a drying oven at 140°C to a coating weight of 0.85 g/m$^2$.

(Photosensitive layer-forming coating solution A)

| | |
|---|---|
| * Esterification product of naphthoquinone-1,2-diazide-5-sulfonyl chloride and a pyrogallol-acetone resin (described in Example 1 of US 3635709) | 0.45 g |
| * N-(4-aminosulfonylphenyl)methacrylamide/ methyl methacrylate (molar ratio: 34:66; weight-average molecular weight: 51,000) | 1.10 g |
| * 2-(p-methoxyphenyl)-4,6-bis (trichloromethyl)-s-triazine | 0.02 g |
| * Tetrahydrophthalic anhydride | 0.05 g |
| * Victoria Pure Blue BOH (available from Hodogaya Chemcial Co., Ltd.) | 0.01 g |
| * Megaface F-177 (fluorosurfactant from Dainippon Ink and Chemicals, Inc.) | 0.006 g |
| * Pluronic F-108 (polyoxyethylene-polyoxypropylene block copolymer from ADEKA CORPORATION) | 0.02 g |
| * Methyl ethyl ketone 10 g | |
| * 1-Methoxy-2-propanol | 10 g |

(F) Pattern Image Formation and Removal of Bottom of Oxide Film

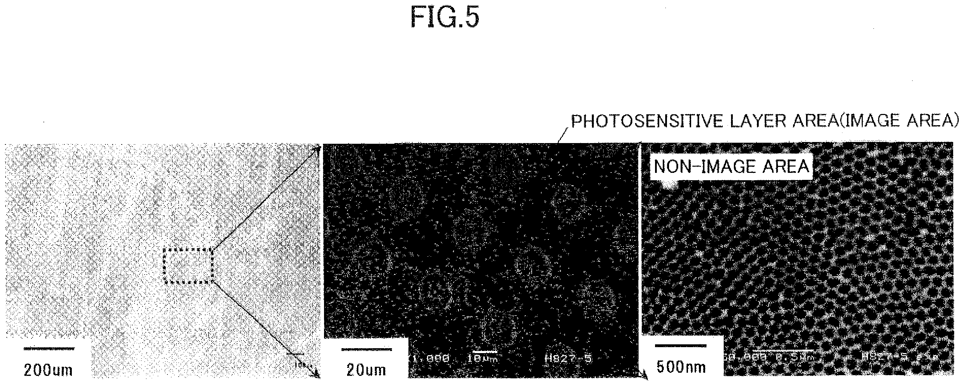

In order to form a pattern image on the structure obtained as above, the structure was then exposed with a 30 A carbon arc light at a distance of 70 cm with a transparent positive image in a 10 $\mu$m-diameter lattice pattern attached in close contact therewith. Then, 0.1 M KOH was used to develop the microstructure at 25°C for 20 minutes to remove non-image areas of the photosensitive layer and further remove the bottom of the anodized film that emerged under the removed layer to thereby prepare a structure having a patterned anodized film having through micropores. The results of the SEM surface images are shown in FIG. 5.

(G) Metal Filling Treatment

Next, gold was vapor-deposited on the side of the structure having the pattern formed thereon after heating treatment to attach a gold electrode in close contact therewith, and electrolytic plating was carried out using the gold electrode as the cathode and copper as the anode.

A mixed solution of copper sulfate = 200/50/15 (g/L) held at 25°C was used as the electrolytic solution to carry out constant-voltage pulse electrolysis, thereby manufacturing a microstructure having the through micropores filled with copper.

An electroplating system manufactured by Yamamoto-MS Co., Ltd. and a power supply (HZ-3000) manufactured by Hokuto Denko Corp. were used to carry out constant-voltage pulse electrolysis. The deposition potential was checked by carrying out cyclic voltammetry in the plating solution, following which the film side potential was set to -2 V and electrolysis was carried out. The pulse waveform in constant-voltage pulse electrolysis was a square waveform. Specifically, electrolysis treatments lasting 60 seconds at a time were carried out a total of five times with 40-second rest periods between the respective treatments, so as to provide a total electrolysis treatment time of 300 seconds.

The surface of the anodized film after filling with copper was observed by FE-SEM and as a result the copper was found to partially protrude therefrom.

(H) Surface Planarizing Treatment

Next, CMP treatment was carried out on the front and back sides of the copper-filled structure.

PLANERLITE-7000 (available from Fujimi Inc.) was used as the CMP slurry.

(I) Trimming Treatment

The CMP-treated structure was then immersed in a phosphoric acid solution so as to selectively dissolve the anodized film, thereby causing the copper columns serving as the conductive paths to protrude from the surface.

The same phosphoric acid solution as in the above-described perforating treatment was used, and the treatment time was set to 5 minutes.

Then, the structure was rinsed with water, dried and observed by EF-SEM.

As a result, it was confirmed that copper was only filled into the pores within the 10 $\mu$m-diameter areas, the protruded portions of the conductive paths had a height (bump height) of 10 nm, the conductive path diameter which is the size of the electrode portion was 40 nm and the member had a thickness of 50 $\mu$m.

(Example 2)

The respective treatments (A) to (H) were carried out as in Example 1 and a treatment for covering the copper protruded from the surfaces of the insulating base (anodized film) with gold.

More specifically, the microstructure obtained after trimming treatment in Example 1 was plated by immersion at 70°C for 10 seconds in a gold electroless plating solution (Melplate AU-601 from Meltex Inc.).

The microstructure was observed by EF-SEM as in Example 1 and the protruded portions were found to be rounded and to have an increased bump height of about 20 nm. It was also confirmed that the conductive path diameter which is the size of the electrode portion was 40 nm and the member had a thickness of 50 $\mu$m.

(Example 3)

Example 1 was repeated under the same conditions except that preliminary anodizing treatment and re-anodizing treatment in the anodizing treatment step B (self-ordering method I) were carried out by using an electrolytic solution of 0.50 mol/L oxalic acid under the following conditions: voltage, 40V; solution temperature, 15°C; solution flow velocity, 3.0 m/min, and trimming treatment (G) was carried out for 10 minutes, thereby manufacturing a microstructure.

The microstructure was observed by EF-SEM as in Example 1 and it was confirmed that the bump height was 40 nm, the conductive path diameter which is the size of the electrode portion was 120 nm and the member had a thickness of 50 μm.

**Claims**

1. A method of manufacturing a microstructure (1) comprising a base (2) having through micropores (3,4) at a density of at least $10^7$ micropores/mm$^2$, part of the through micropores (3,4) being filled with other material than a material of the base (2),
   wherein an aluminum substrate (12) is subjected at least to, in order,
   a treatment A for anodizing the aluminum substrate (12) to form an oxide film (14a,14b,14c,14d) having micropores (16a,16b,16c,16d);
   a treatment B for removing aluminum from the oxide film (14a,14b,14c,14d) obtained by the treatment A;
   a treatment C for perforating part of the micropores (16a,16b,16c,16d) present in the oxide film (14a,14b,14c,14d) from which the aluminum was removed by the treatment B;
   a treatment D for filling the part of the micropores (16a,16b,16c,16d) that were perforated by the treatment C with a different material from an oxide film material; and
   a step E of surface planarization for removing bottoms of micropores (16a,16b,16c,16d) of the oxide film (14a,14b,14c,14d) that were not perforated in the treatment C to make the unperforated micropores extend through the oxide film (14a,14b,14c,14d), wherein, before performing the treatment A, the surface of the aluminum substrate (12) is subjected to a mirror-like finishing treatment, and wherein, in order to perforate the part of the micropores (16a,16b,16c,16d) present in the oxide film (14a,14b,14c,14d) in the treatment C, the treatment C comprises at least a treatment C' which comprises:

   forming a pattern which is insoluble or hardly soluble in an acid or an alkali on a surface of the oxide film (14a,14b,14c,14d) after removal of the aluminum; and
   dissolving portions other than the pattern in the oxide film (14a,14b,14c,14d) by using the acid or the alkali to make the micropores (16a,16b,16c,16d) formed in the portions other than the pattern in the oxide film (14a,14b,14c,14d) extend through the oxide film (14a,14b,14c,14d).

2. The microstructure manufacturing method according to claim 1, wherein the treatment C' comprises at least a treatment C'-1 which comprises:

   forming a photosensitive layer in which solubility with respect to the acid or the alkali changes in response to light on the surface of the oxide film after the removal of the aluminum;
   irradiating the photosensitive layer with light beams; and
   dissolving the photosensitive layer by using the acid or the alkali to form the pattern which is insoluble or hardly soluble in the acid or the alkali on the surface of the oxide film after the removal of the aluminum.

3. The microstructure manufacturing method according to claim 1, wherein the treatment C' comprises at least a treatment C'-2 which comprises:

   forming a thermosensitive layer in which solubility with respect to the acid or the alkali changes in response to heat on the surface of the oxide film after the removal of the aluminum;
   heating the thermosensitive layer; and
   dissolving the thermosensitive layer by using the acid or the alkali to form the pattern which is insoluble or hardly soluble in the acid or the alkali on the surface of the oxide film after the removal of the aluminum.

4. The microstructure manufacturing method according to any one of claims 1 to 3, wherein, in the treatment D, the different material from the oxide film material filled into the micropores that were made to extend through the oxide film by the treatment C is an electrically conductive material.

5. The microstructure manufacturing method according to claim 4, wherein, in the treatment D, the micropores that were made to extend through the oxide film by the treatment C are filled with the electrically conductive material by electrolytic plating.

**Patentansprüche**

1. Verfahren zur Herstellung einer Mikrostruktur (1), umfassend eine Basis (2), die durchstoßende Mikroporen (3, 4) in einer Dichte von mindestens $10^7$ Mikroporen/mm$^2$ aufweist, wobei ein Teil der durchstoßenden Mikroporen (3, 4) mit einem Material gefüllt ist, das sich vom Material der Basis (2) unterscheidet, worin ein Aluminiumsubstrat (12) in Reihenfolge unterzogen wird zumindest

   einer Behandlung A zum Anodisieren des Aluminiumsubstrats (12), um einen Oxidfilm (14a, 14b, 14c, 14d) zu bilden, der Mikroporen (16a, 16b, 16c, 16d) aufweist;

   einer Behandlung B zum Entfernen von Aluminium aus dem Oxidfilm (14a, 14b, 14c, 14d), der durch die Behandlung A erhalten wird;

   einer Behandlung C zum Perforieren eines Teils der Mikroporen (16a, 16b, 16c, 16d), die in dem Oxidfilm (14a, 14b, 14c, 14d) vorliegen, aus dem Aluminium durch die Behandlung B entfernt worden ist;

   einer Behandlung D zum Füllen des Teils der Mikroporen (16a, 16b, 16c, 16d), die durch die Behandlung C perforiert worden sind, mit einem Material, das sich von einem Oxidfilmmaterial unterscheidet; und

   einem Schritt E der Oberflächenplanarisierung zum Entfernen von Böden der Mikroporen (16a, 16b, 16c, 16d) des Oxidfilms (14a, 14b, 14c, 14d), die nicht in der Behandlung C perforiert worden sind, damit die nichtperforierten Mikroporen sich durch den Oxidfilm (14a, 14b, 14c, 14d) erstrecken, worin vor dem Durchführen der Behandlung A die Oberfläche des Aluminiumsubstrats (12) einer spiegelartigen Finish-Behandlung unterzogen wird, und worin zur Perforierung des Teils der Mikroporen (16a, 16b, 16c, 16d), die in dem Oxidfilm (14a, 14b, 14c, 14d) vorliegen, in der Behandlung C die Behandlung zumindest eine Behandlung C' umfasst, die umfasst:

   Bilden einer Struktur, die in einer Säure oder einem Alkalimittel unlöslich oder kaum löslich ist, auf einer Oberfläche des Oxidfilms (14a, 14b, 14c, 14d), nach dem Entfernen des Aluminiums; und

   Auflösen von Teilen außer der Struktur in dem Oxidfilm (14a, 14b, 14c, 14d) durch Verwendung der Säure oder des Alkalimittels, damit die Mikroporen (16a, 16b, 16c, 16d), die in den Bereichen außerhalb der Struktur in dem Oxidfilm (14a, 14b, 14c, 14d) gebildet sind, sich durch den Oxidfilm (14a, 14b, 14c, 14d) erstrecken.

2. Mikrostruktur-Herstellungsverfahren gemäß Anspruch 1, worin die Behandlung C' zumindest eine Behandlung C'-1 umfasst, die umfasst:

   Bilden einer fotoempfindlichen Schicht, worin sich die Löslichkeit im Hinblick auf die Säure oder das Alkalimittel in Erwiderung auf Licht verändert, auf der Oberfläche des Oxidfilms nach dem Entfernen des Aluminiums;

   Bestrahlen der fotoempfindlichen Schicht mit Lichtstrahlen; und

   Auflösen der fotoempfindlichen Schicht unter Verwendung der Säure oder des Alkalimittels, um die Struktur, die in der Säure oder dem Alkalimittel unlöslich oder kaum löslich ist, auf der Oberfläche des Oxidfilms nach dem Entfernen des Aluminiums zu bilden.

3. Mikrostruktur-Herstellungsverfahren gemäß Anspruch 1, worin die Behandlung C' zumindest eine Behandlung C'-2 umfasst, die umfasst:

   Bilden einer thermoempfindlichen Schicht, worin sich die Löslichkeit im Hinblick auf die Säure oder das Alkalimittel in Erwiderung auf Wärme verändert, auf der Oberfläche des Oxidfilms nach dem Entfernen des Aluminiums;

   Erwärmen der thermoempfindlichen Schicht; und

   Auflösen der thermoempfindlichen Schicht unter Verwendung der Säure oder des Alkalimittels, um die Struktur, die in der Säure oder dem Alkalimittel unlöslich oder kaum löslich ist, auf der Oberfläche des Oxidfilms nach dem Entfernen des Aluminiums zu bilden.

4. Mikrostruktur-Herstellungsverfahren gemäß irgendeinem der Ansprüche 1 bis 3, worin in der Behandlung D das Material, das sich von dem Oxidfilmmaterial unterscheidet, welches in die Mikroporen gefüllt wird, bei denen durch die Behandlung C verursacht wurde, dass sie sich durch den Oxidfilm sich erstrecken, ein elektrisch leitfähiges Material ist.

5. Mikrostruktur-Herstellungsverfahren gemäß Anspruch 4, worin in der Behandlung D die Mikroporen, bei denen durch die Behandlung C verursacht wurde, dass sie sich durch den Oxidfilm erstrecken, mit dem elektrisch leitfähigen Material durch elektrolytisches Plattieren gefüllt werden.

**Revendications**

1.  Procédé de fabrication d'une microstructure (1) comprenant une base (2) ayant des micropores traversants (3,4) à une densité d'au moins $10^7$ micropores/mm$^2$, une partie des micropores traversants (3,4) étant remplis avec un autre matériau qu'un matériau de la base (2),
    dans lequel un substrat d'aluminium (12) est soumis à au moins, dans l'ordre,
    un traitement A pour anodiser le substrat d'aluminium (12) pour former un film d'oxyde (14a, 14b, 14c, 14d) ayant des micropores (16a, 16b, 16c, 16d) ;
    un traitement B pour éliminer l'aluminium du film d'oxyde (14a, 14b, 14c, 14d) obtenu par le traitement A ;
    un traitement C pour perforer une partie des micropores (16a, 16b, 16c, 16d) présents dans le film d'oxyde (14a, 14b, 14c, 14d) duquel l'aluminium a été éliminé par le traitement B ;
    un traitement D pour remplir la partie des micropores (16a, 16b, 16c, 16d) qui ont été perforés par le traitement C avec un matériau différent d'un matériau de film d'oxyde ; et
    une étape E de planarisation de surface pour éliminer les fonds de micropores (16a, 16b, 16c, 16d) du film d'oxyde (14a, 14b, 14c, 14d) qui n'ont pas été perforés dans le traitement C pour amener les micropores non perforés à s'étendre à travers le film d'oxyde (14a, 14b, 14c, 14d), dans lequel, avant d'effectuer le traitement A, la surface du substrat d'aluminium (12) est soumise à un traitement de finition de type miroir, et dans lequel, afin de perforer la partie des micropores (16a, 16b, 16c, 16d) présents dans le film d'oxyde (14a, 14b, 14c, 14d) dans le traitement C, le traitement C comprend au moins un traitement C' qui comprend :

    la formation d'un motif qui est insoluble ou peu soluble dans un acide ou un alcali sur une surface du film d'oxyde (14a, 14b, 14c, 14d) après élimination de l'aluminium ; et
    la dissolution de parties autres que le motif dans le film d'oxyde (14a, 14b, 14c, 14d) à l'aide de l'acide ou de l'alcali pour amener les micropores (16a, 16b, 16c, 16d) formés dans les parties autres que le motif dans le film d'oxyde (14a, 14b, 14c, 14d) à s'étendre à travers le film d'oxyde (14a, 14b, 14c, 14d).

2.  Procédé de fabrication de microstructure selon la revendication 1, dans lequel le traitement C' comprend au moins un traitement C'-1 qui comprend :

    la formation d'une couche photosensible dans laquelle la solubilité par rapport à l'acide ou à l'alcali change en réponse à la lumière sur la surface du film d'oxyde après l'élimination de l'aluminium ;
    l'irradiation de la couche photosensible avec des faisceaux de lumière ; et
    la dissolution de la couche photosensible à l'aide de l'acide ou de l'alcali pour former le motif qui est insoluble ou peu soluble dans l'acide ou l'alcali sur la surface du film d'oxyde après l'élimination de l'aluminium.

3.  Procédé de fabrication de microstructure selon la revendication 1, dans lequel le traitement C' comprend au moins un traitement C'-2 qui comprend :

    la formation d'une couche thermosensible dans laquelle la solubilité par rapport à l'acide ou l'alcali change en réponse à la chaleur sur la surface du film d'oxyde après l'élimination de l'aluminium ;
    le chauffage de la couche thermosensible ; et
    la dissolution de la couche thermosensible à l'aide de l'acide ou de l'alcali pour former le motif qui est insoluble ou peu soluble dans l'acide ou l'alcali sur la surface du film d'oxyde après l'élimination de l'aluminium.

4.  Procédé de fabrication de microstructure selon l'une quelconque des revendications 1 à 3, dans lequel, dans le traitement D, le matériau différent du matériau de film d'oxyde introduit dans les micropores qui ont été amenés à s'étendre à travers le film d'oxyde par le traitement C est un matériau électro-conducteur.

5.  Procédé de fabrication de microstructure selon la revendication 4, dans lequel, dans le traitement D, les micropores qui ont été amenés à s'étendre à travers le film d'oxyde par le traitement C sont remplis avec le matériau électro-conducteur par dépôt électrolytique.

# FIG.1A

# FIG.1B

# FIG.2A

# FIG.2B

FIG.3A

16a

14a

18a

12

FIG.3B

16b

14b

18b

12

FIG.3C

16c

14c

18c

12

FIG.3D

16d

14d

18d

12

FIG.4A

FIG.4B

FIG.4C

FIG.4D

# FIG.5

PHOTOSENSITIVE LAYER AREA(IMAGE AREA)

NON-IMAGE AREA

200um

20um

500nm

EP 2 213 771 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000012619 A
- JP 2005085634 A
- JP 2002134570 A
- JP 3182081 A
- JP 2004285405 A
- US 2708655 A
- JP 10121292 A
- JP 2001105400 A
- JP 2003129288 A
- JP 7285275 A
- WO 9739894 A
- JP 11044956 A
- JP 11218914 A
- US 6352812 B1
- US 6352811 B1
- US 6358669 B1
- US 6534238 B1
- EP 864420 B1
- JP 5197137 A
- JP 8320551 A
- JP 10195119 A
- US 3635709 A

**Non-patent literature cited in the description**

- Aluminum Handbook. Aluminum Association, 2001, 164-165
- *Jitsumu Hyomen Gijutsu (Practice of Surface Technology),* 1986, vol. 33 (3), 32-38